## Europäisches Patentamt

(19) **European Patent Office**

**Office européen des brevets**

(11) Publication number: **0 282 557 B1**

## EUROPEAN PATENT SPECIFICATION

(45) Date of publication of patent specification: **15.12.93**

(51) Int. Cl.5: **H01L 29/10**, H01L 29/784

(21) Application number: **87906251.1**

(22) Date of filing: **03.09.87**

(86) International application number:
**PCT/US87/02202**

(87) International publication number:
**WO 88/02186 (24.03.88 88/07)**

(54) **OUTPUT CIRCUIT FOR IMAGE SENSOR.**

(30) Priority: **18.09.86 US 908851**
**23.06.87 US 65686**

(43) Date of publication of application:
**21.09.88 Bulletin 88/38**

(45) Publication of the grant of the patent:
**15.12.93 Bulletin 93/50**

(84) Designated Contracting States:
**DE FR GB**

(56) References cited:

**IEEE Transactions on Electron Devices, volume ED-31, no. 12, December 1984, IEEE, (New York, US), J. Hynecek: "Design and performance of a low-noise charge-detection amplifier for VPCCD devices", pages 1713-1719, see page 1715**

**Patent Abstracts of Japan, vol. 5, no. 91 (E-61)(763), 13 June 1981, & JP, A, 5636272**

(73) Proprietor: **EASTMAN KODAK COMPANY (a New Jersey corporation)**
**343 State Street**
**Rochester New York 14650(US)**

(72) Inventor: **STEVENS, Eric, G.**
**45 Wheeldon Drive**
**Rochester, NY 14616(US)**

(74) Representative: **Buff, Michel et al**
**Kodak-Pathé**
**Département des Brevets et Licences CRT**
**Centre de Recherches et de Technologie**
**Zone Industrielle**
**F-71102 Chalon sur Saône Cédex (FR)**

Rank Xerox (UK) Business Services
(3.10/3.6/3.3.1)

## Description

Technical field

The present invention relates to output circuits for sequentially receiving and then converting charge collected in the photoelements of an image sensor into an output voltage.

Background Art

The resolution of image sensors is increased by increasing the number of photoelements of such sensors. As the number of photoelements increases, their size necessarily decreases for a given sensor image area. Charge is collected by these photoelements and transferred to an outpur circuit which includes a floating diffusion (FD). Abstract of JP-A-56.36272 published in Patent abstracts of Japan Vol. 5 No 91 (E-61) [763] of June 13, 1981 describes a circuit for receiving charges and converting the charges into an output voltage comprising a first transistor where the source electrode is floating and a signal is applied to the gate of said transistor to reset the floating source. Connected to the floating source of said first transistor is a source follower amplifier for producing a signal in response to charge collected in said floating source. However nothing is mentioned as regards the structure of the transistor. This output circuit is adapted to convert charge into an output voltage.

As the size of sensor elements decreases, the number of signal charge they collect also decreases. Unfortunately, the portion of the output signal caused by noise actually increases. Noise therefore becomes a more significant component of any output signal. Consider that we have a given photoelement signal charge ($Q_{sig}$) as determined by its responsivity and signal exposure level. Such charge is independent of the sense node's capacitance ($C_{FD}$). Also consider that the source-follower output circuit as described herein has a given input-referred noise voltage $\overline{(Vi_{SF}^2)}$ primarily due to thermal noise of the first-stage drive transistor. Thermal noise is also independant of $C_{FD}$ for a given transistor width-to-length ratio (W/L) as determined by drive requirements.

$\overline{(Vi_{SF}^2)}$ can be converted to an input-referred noise in terms of charge by the expression,

$$\overline{Qi_{SF}^2} = \overline{C_{FD}^2 Vi_{SF}^2}.$$

Another noise term associated with the described output circuit is termed reset or kTC noise, and is given in terms of charge by the expression,

$$\overline{Q_{KTC}^2} = kTC_{FD},$$

where k is Boltzman's constant and T is the temperature. Therefore the signal-to-noise ratio (S/N) is given by,

$$S/N = \frac{Qsig}{\sqrt{kTC_{FD} + C_{FD}^2 Vi_{SF}^2 + \text{other terms}}}.$$

where the other terms are also independent of $C_{FD}$. From this expression, it can be seen that the signal-to-noise ratio is improved by decreasing $C_{FD}$.

The Article of J. Hynecek published in IEEE transactions on Electron Devices ED-31, Dec. 1984, No 12 pages 1713 to 1719 and entitled "Design and performance of a Low-Noise charge detection Amplifier for VPCCD devices" describes the use of buried-channel MOS transistor with lightly doped source and drain extensions that help reduce hot-electron effects and improve decreasing capacitance ($C_{FD}$).

It is therefore an object of the present invention to provide a highly-sensitive floating-diffusion electrometer design which minimizes input capacitance and thereby reduces noise in the total output signal voltage by modifying the structure proposed in Hynecek's article.

Disclosure of the invention

This object is achieved by an output circuit for sequentially receiving charge and converting such charge collected in photoelements of an image sensor into an output signal which contains noise, said circuit comprising :

a) a first buried-channel MOS transistor (QR) having a gate electrode, a channel region under the gate electrode, and source and drain electrodes, said source electrode having a highly doped region spaced from the channel region and a more lightly doped region between the highly doped region and the channel region to provide a floating diffusion with reduced capacitance ;

b) means for selectively applying pulses to the gate electrode of said first transistor to reset the potential across said floating diffusion and prepare it to receive charge produced in a photoelement ; and

c) an output source-follower amplifier having a second buried-channel MOS transistor ($QD_1$) comprising, a gate electrode which is electrically connected to said floating diffusion a channel region under the gate electrode, highly doped source and drain regions at opposite sides of the channel region and a more lightly doped region between the highly doped drain region and the channel region of said second transistor, whereby said amplifier produces a change in output voltage in response to charge collected in said floating diffusion with an improved signal to noise ratio.

b. an output source-follower amplifier having a second buried-channel LDD transistor electrically connected to said floating diffusion, said source-follower amplifier producing an output voltage in response to charge collected in such floating diffusion.

## Brief Description of the Drawings

Fig. 1 is a block diagram of the basic elements of an image sensor in accordance with the present invention;

Fig. 2 shows in schematic form the output circuit 18 shown in Fig. 1;

Fig. 3 is a top view showing the layout of portions of the output circuit 18;

Fig. 4 is a sectional view taken along the lines A-A of Fig. 3;

Fig. 5 is a sectional view taken along the lines B-B of Fig. 3; and

Fig. 6 is a sectional view taken along the lines C-C of Fig. 3.

For convenience of illustration, none of the drawings are to scale.

## Modes of Carrying Out the Invention

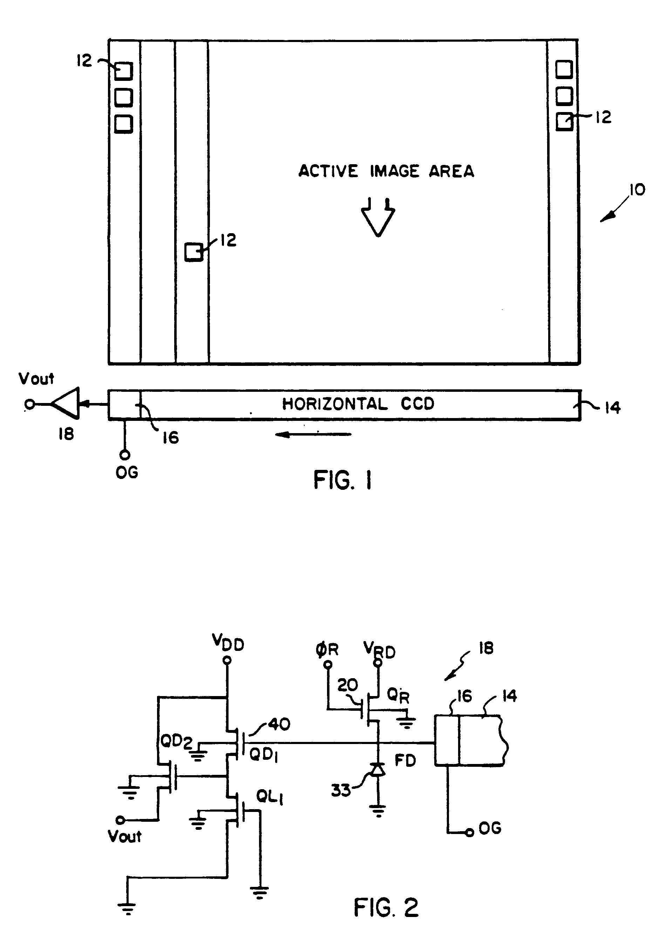

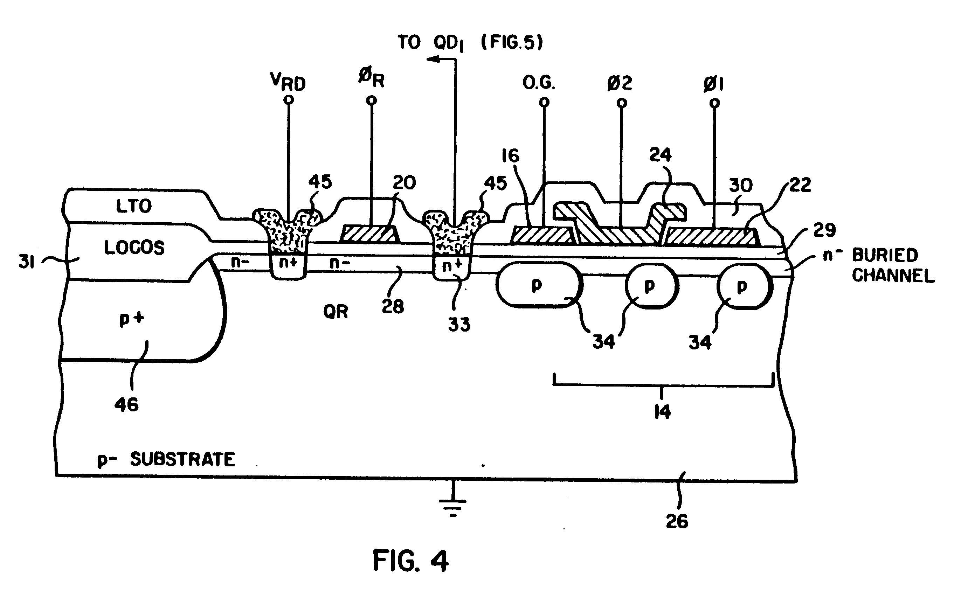

Turning first to Fig. 1, there is shown in block diagrammatic form a full-frame image sensor 10. The image sensor 10 includes photoelements 12 which collect charge as a linear function of the intensity of incident light and integration time, and as a non-linear function of incident light wavelength. Each photoelement represents one pixel of an image scene. These photoelements can for example be photocapacitors which accumulate electrons in an n region of a buried channel. During readout, charge is transferred vertically from photocapacitor to photocapacitor in each column to a buried-channel horizontal charge-coupled device (CCD) 14. A portion of the charge-coupled device is shown in more detail in Fig. 4. Each packet of electrons from each photoelement is sequentially delivered to a horizontal CCD element preceding an output gate 16 and then from this element through the output gate to an output circuit 18. The output circuit 18 is integrated on the same chip as the sensor 10. The output circuit 18 provides an output voltage $V_{out}$ proportional to each packet of electrons (charge) it receives. The output circuit 18 includes a floating diffusion 33 (FD) which, as will be seen, has its effective capacitance minimized to reduce noise in the output signal.

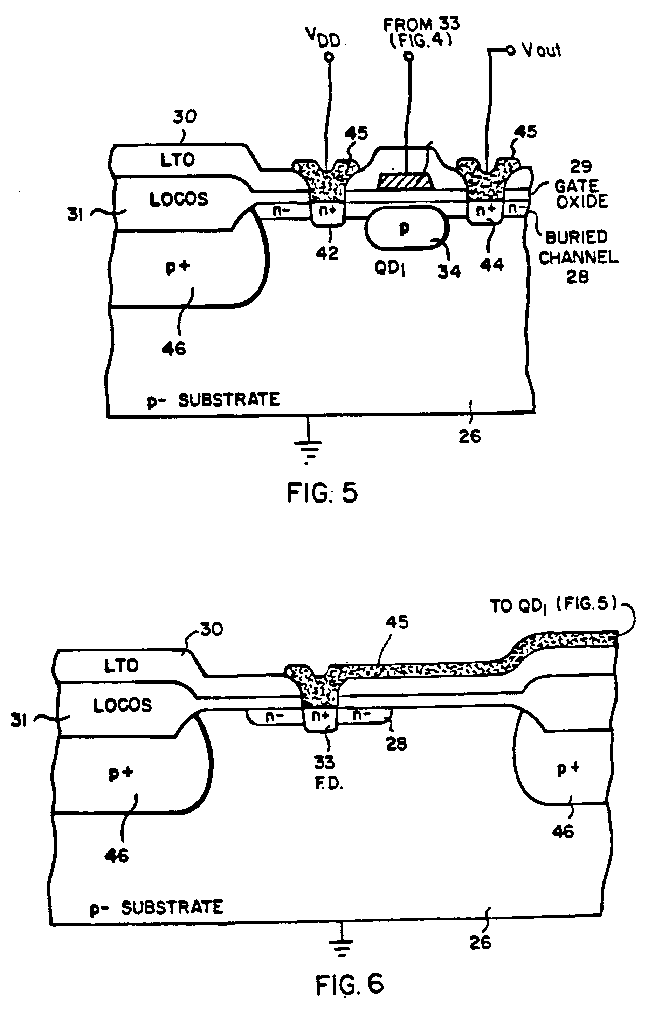

Turning now to Fig. 2, the circuit 18 is shown in schematic form. In response to the removal of the pulse $\phi R$ applied to the gate electrode 20 of a reset transistor $Q_R$, the transistor $Q_R$ is turned off and shortly thereafter, charge is transferred from under the output gate 16 to a floating diffusion FD, 33. As shown in Fig. 4, the floating diffusion is actually the source electrode 33 of the transistor $Q_R$. When the pulse $\phi R$ is applied, the transistor $Q_R$ is turned on and the potential across the floating diffusion FD is returned to a reference level set by $V_{RD}$, the reset drain potential. When transistor $Q_R$ is off, a potential well is created in the floating diffusion. Electrons are once again transferred to this potential well from the output gate 16. The floating diffusion 33 is electrically connected to the gate electrode of a transistor $QD_1$ of the first stage of the source-follower output amplifier 18. In this first stage, there are two transistors $QD_1$ and $QL_1$. Both of these transistors continuously operate in a saturated mode. At the electrical junction of the transistors $QD_1$ and $QL_1$, a voltage is produced which follows the voltage level across the floating diffusion FD. This voltage is applied as an input to the gate electrode of transistor $QD_2$. The drain of $QD_2$ is connected to the same potential source $V_{dd}$ which is coupled to the drain of transistor $QD_1$. All of the transistors, $Q_R$, $QD_1$, $QL_1$ and $QD_2$ are NMOS lightly-diffused drain (LDD) buried-channel transistors. Transistor $QD_1$ is shown in section in Fig. 5. The output voltage $V_{out}$ is taken from the source electrode of transistor $QD_2$. $V_{out}$ is applied as an input to conventional off-chip signal processing circuitry.

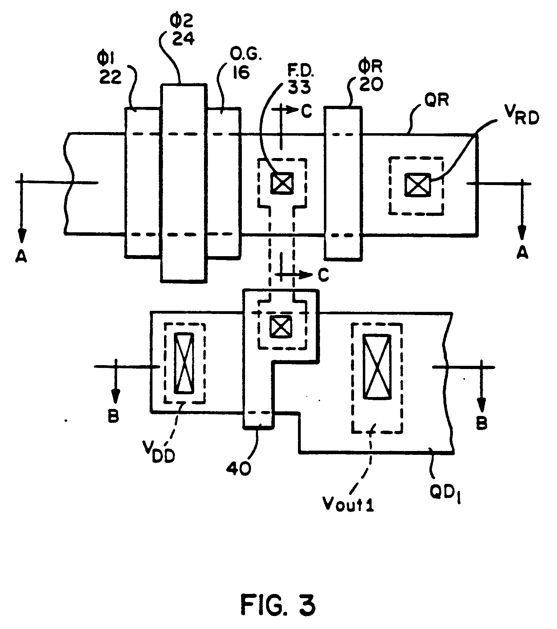

Fig. 3 shows a top layout view of transistor $Q_R$ and transistor $QD_1$ of the first stage of the source-follower output amplifier 18. Fig. 3 should be consulted during the description of Figs. 4 and 5. Turning now to Fig. 4 where there is shown in cross-section the reset transistor $Q_R$ and the output gate 16 and two gates of the horizontal CCD 14. The CCD 14 is shown as a two-phase device. There are two levels of polysilicon, poly-1 and poly-2 which respectively provide shift register gate electrodes 22 and 24. A substrate 26 is of a p-type conductivity and an n-type layer 28, which can be provided by implanting arsenic into the substrate 26, provides a buried-channel structure. Directly over the n-type layer 28 is a layer of thermally grown silicon dioxide 29. Directly over the p-type substrate 26 is a $p^+$ field threshold adjust implant 46 in the non-active regions of the device. Over the $P^+$ field threshold adjusted regions 46 is a thick field silicon dioxide layer 31 provided by a conventional LOCOS (Local Oxidation of Silicon) process.

CCD shift register electrodes 22 and 24 are formed on the thin gate oxide 29. Separating each of the electrodes is an insulating layer 30 of silicon dioxide which is provided by a conventional LTO (Low Temperature Oxide). The output gate 16 has a positive potential $V_{OG}$ continuously applied to the electrode. If we assume that electrons are held under the last gate 24 of the horizontal shift CCD 14 and that at this time the gate potential $\phi_2$ is reduced while the gate potential $\phi_1$ is raised, the electrons will flow down a "potential hill" under the output gate 16 to the floating diffusion 33. At this time, the transistor $Q_R$ is off; that is, signal electrons collect on the source electrode 33. The transistor $Q_R$ is an NMOS LDD buried-channel transistor. The source electrode 33 provides the function of a floating diffusion FD. The electrode 33 is a floating diffusion because the potential developed across it is allowed to float when the transistor $Q_R$ is off. The floating diffusion is provided at the PN junction between the $n^+$ diffused electrode and p (substrate) regions. Then when the pulse $\phi R$ is applied to the gate electrode 20 of transistor $Q_R$, the transistor $Q_R$ turns on and the potential across the floating diffusion 33 is reset by the electrons draining off onto the drain of transistor $Q_R$ which is at a potential $V_{RD}$. During these times, a voltage change is produced across the floating diffusion which is electrically connected to the gate electrode 40 of transistor $QD_1$ shown in Figs. 2 and 5. As shown in Fig. 5, transistor $QD_1$ is also an NMOS LDD buried-channel transistor.

The transistor $Q_R$, $QD_1$, $QL_1$ and $QD_2$ are constructed by defining the active and field regions through a conventional LOCOS process. All these transistors are formed by implanting arsenic to form the buried-channel layer 28. By using buried-channel transistors, as opposed to surface-channel transistors, the flicker noise component of the transistors is reduced since the carriers do not interact as strongly with silicon-silicon dioxide interface states. This buried-channel implant layer 28 also serves to replace the $n^-$ source and drain implanted regions typically used to form LDD NMOSFETs thereby simplifying the process. In accordance with the invention, the use of an LDD structure which has the $n^-$ layer 28 connected to $n^+$ source and $n^+$ drain electrodes as shown, causes the gate-to-source and drain overlap capacitances to be greatly reduced. This capacitance makes up part of the total capacitance at the sensing node FD 33. In addition, the $n^-$ buried-channel layer 28 is separated from the $p^+$ field implanted regions 46 at the source node 33 of QR which forms the floating diffusion as shown in Fig. 6. This serves to reduce the floating diffusion's sidewall junction capacitance, and hence the total capacitance of the sensing node FD, since the depletion spreading is increased. A boron FET threshold voltage adjust implant 34 is implanted through the gate electrodes for the following elements: $QD_1$ (see Fig. 5), $QL_1$, $QD_2$ and OG. A number of conventional processes can be used to provide these implants 34. A particularly suitable process is described in commonly assigned EP-A-0207328, entitled "Method of Making Edge-Aligned Implants and Electrodes Therefor" in the names of Losee and Lavine. The disclosure of this application is incorporated by reference herein. The $n^+$ source and $n^+$ drain electrodes of the transistors have been constructed by implanting arsenic though source and drain contact holes etched through the overlaying LTO layer 30 into layer 28. This saves a masking step hence simplifying the construction of these electrodes, and results in the $n^+$ contacts being self-aligned. This also stops the $n^+$ source and drain regions from spreading beneath the polysilicon gates (see Figs. 4 and 5), by lateral diffusion thereby greatly reducing the overlap capacitance. Aluminum contacts 45 are sputtered into the etched holes to make electrical connection with the electrodes. Since the $n^+$ source/drain regions are also separated from the $p^+$ field or channel stop regions 46 (see Figs. 5 and 6), the capacitance of the reverse biased junctions is also reduced due to an increased depletion region width. An added advantage of separating the $n^+$ regions off of the $p^+$ regions is an increase of the diode's reverse-bias breakdown voltage.

Fig. 5 will now be described. The NMOS LDD buried-channel transistor $QD_1$ includes a drain electrode 42 and a source electrode 44. A $p^+$ region 46 provides a field threshold adjust function. It will be understood that a lightly-doped p region 34 may be provided just under the layer 28 to adjust the threshold voltage of the transistor as discussed above in connection with $QD_1$. This p region 34 can be provided by conventional boron ion implantation.

It has also been found quite advantageous to have transistors $QL_1$ and $QD_2$ as NMOS LDD buried-channel transistors, which increase speed by reducing the capacitive load seen at the output of the first-stage source-follower.

The effective floating diffusion capacitance is reduced for three reasons. The first is by reducing the gate-to-drain and source overlap capacitance since the $n^+$ regions are offset far enough from the gate so that it will not diffuse laterally underneath the gate. This reduction is effected through the use of the LDD structure. The second reduction in capacitance is effected by the separation of the $n^+$ floating diffusion region from the $p^+$ field threshold adjust regions. The third reduction in effective floating diffusion capacitance results from separating the CCD buried-channel $n^-$ region 28 at the floating diffusion from the $p^+$ field threshold adjust regions 46 as shown in Fig. 6. This causes a larger depletion region of this reverse biased junction which results in a lower junction capacitance.

In accordance with this invention, an output circuit was constructed in accordance with the present invention using four buried-channel NMOS, LDD transistors. Each of these transistors employed self-aligned $n^+$ contacts. By means of this arrangement, an effective floating diffusion capacitance of approximately 10 fF was obtained. The circuit provided low-flicker noise with a relatively high output voltage. Flicker noise was reduced by using buried-channel transistors.

Industrial Applicability and Advantages

The output circuit of the present is particularly useful in image sensors.

Among the features of this integrated-output circuit are that it has low-power dissipation, requires very little surface area and is quite versatile.

This circuit reduces noise in the output voltage through high input-referred sensitivity and also increases reliability and simplicity of overall system design. NMOS transistors are particularly suitable for use in the present invention.

**Claims**

1. An output circuit for sequentially receiving charge and converting such charge collected in photoelements of an image sensor into an output signal which contains noise, said circuit comprising :

    a) a first buried-channel MOS transistor (QR) having a gate electrode (20), a channel region (28) under the gate electrode, and source and drain electrodes, said source electrode having a highly doped region spaced from the channel region and a more lightly doped region between the highly doped region (34) and the channel region to provide a floating diffusion (33) with reduced capacitance ;

    b) means for selectively applying pulses to the gate electrode (20) of said first transistor to reset the potential across said floating diffusion (33) and prepare it to receive charge produced in a photoelement ; and

    c) an output source-follower amplifier having a second buried-channel MOS transistor ($QD_1$) comprising, a gate electrode (40) which is electrically connected to said floating diffusion, a channel region (28) under the gate electrode, highly doped source and drain regions at opposite sides of the channel region and a more lightly doped region between the highly doped drain region and the channel region of said second transistor, whereby said amplifier produces a change in output voltage in response to charge collected in said floating diffusion with an improved signal to noise ratio.

2. The output circuit as set forth in claim 1 wherein said output source-follower amplifier is a two-stage configuration including said second transistor in the first stage.

3. The output circuit as set forth in claim 1, wherein said second transistor comprises a (p-) substrate, a channel region in the substrate, an insulating layer on the channel region, a gate electrode on said insulating layer and over the channel region, and highly doped source and drain electrodes in the substrate and each spaced from the channel region by a more lightly doped region.

4. The output circuit as set forth in claim 3 in which the buried-channel of the first MOS transistor is a more lightly doped region spaced from the source electrode.

5. The output circuit as set forth in claim 4 in which the more lightly doped region between the source and the channel region is an extension of the channel region.

6. The output circuit as set forth in claim 1 further comprising a highly doped field threshold adjust region around the first MOS transistor with the lightly doped region adjacent the floating diffusion being spaced from the threshold adjust region.

7. The output circuit as set forth in claim 1 in which the buried-channel of the second MOS transistor is a more lightly doped region spaced from the drain electrode.

8. The output circuit as set forth in claim 7 in which the more lightly doped region between the drain and the channel region of the second MOS transistor is an extension of the channel region.

9. The output circuit as set forth in claim 3 in which the image sensor comprises a horizontal charge-coupled device to which the photoelements are connected, the charge-coupled device comprises an output gate and a channel region under the output gate, and means connecting the floating diffusion to the channel region of the horizontal charge-coupled device.

10. The output circuit as set forth in claim 9 in which the means connecting the floating diffusion to the channel region of the charge-coupled device comprises a lightly doped region extending between the floating diffusion and the channel region of the charge-coupled device.

11. The output circuit as set forth in claim 10 in which the channel region of the charge-coupled device is a lightly doped region.

12. Image sensor comprising an output circuit as defined in any of the preceding claims.

**Patentansprüche**

1. Ausgangsschaltung, der nacheinander die in Fotoelementen eines Bildsensors gesammelte Ladung zuführbar ist und die diese Ladung in ein Rauschen enthaltendes Ausgangssignal umwandelt, mit
   a) einem ersten MOS-Transistor (QR), der einen vergrabenen Kanal aufweist und eine Gate-Elektrode (20), einen unter der Gate-Elektrode befindlichen Kanalbereich (28) sowie eine Source- und eine Drain-Elektrode besitzt, wobei die Source-Elektrode einen von dem Kanalbereich im Abstand angeordneten hochdotierten Bereich und einen zwischen dem hochdotierten Bereich (34) und dem Kanalbereich liegenden geringer dotierten Bereich aufweist und eine erdfreie Diffusionszone (33) mit verringerter Kapazität ergibt,
   b) Mitteln, mit denen der Gate-Elektrode (20) des ersten Transistors selektiv Impulse zuführbar sind, um das über die erdfreie Diffusionszone (33) wirksame Potential neu einzustellen und für die Aufnahme der in einem Fotoelement erzeugten Ladung vorzubereiten, und
   c) einem Ausgangs-Source-Nachfolgeverstärker, der einen zweiten MOS-Transistor (QD$_1$) mit vergrabenem Kanal aufweist, der eine elektrisch mit der erdfreien Diffusionszone verbundene Gate-Elektrode (40) aufweist und einen unter der Gate-Elektrode liegenden Kanalbereich (28), auf gegenüberliegenden Seiten des Kanalbereichs augeordnete hochdotierte Source- und Drain-Bereiche und einen zwischen dem hochdotierten Drain-Bereich und dem Kanalbereich des zweiten Transistors liegenden geringer dotierten Bereich besitzt, wobei der Verstärker nach Maßgabe der in der erdfreien Diffusionszone angesammelten Ladung eine Veränderung der Ausgangsspannung mit einem verbesserten Signal-Rausch-Verhältnis bewirkt.

2. Ausgangsschaltung nach Anspruch 1, dadurch gekennzeichnet, daß der Ausgangs-Source-Nachfolgeverstärker zweistufig ausgebildet ist und in der ersten Stufe den zweiten Transistor enthält.

3. Ausgangsschaltung nach Anspruch 1, dadurch gekennzeichnet, daß der zweite Transistor ein (p-)-Substrat besitzt, das einen Kanalbereich enthält, daß auf dem Kanalbereich eine isolierende Schicht vorgesehen und auf der isolierenden Schicht und über dem Kanalbereich eine Gate-Elektrode angeordnet ist, und daß sich inm Substrat hochdotierte Source- und Drain-Elektroden befinden, die jweils durch einen geringer dotierten Bereich von dem Kanalbereich getrennt sind.

4. Ausgangsschaltung nach Anspruch 3, dadurch gekennzeichnet, daß der vergrabene Kanal des ersten MOS-Transistors einen von der Source-Elektrode im Abstand liegenden geringer dotierten Bereich darstellt.

**5.** Ausgangsschaltung nach Anspruch 4, dadurch gekennzeichnet, daß es sich bei dem geringer dotierten Bereich zwischen der Source-Elektrode und dem Kanalbereich um eine Verlängerung des Kanalbereichs handelt.

**6.** Ausgangsschaltung nach Anspruch 1, dadurch gekennzeichnet, daß ein hochdotierter Feldschwellen-Einstellbareich um den ersten MOS-Transistor vorgesehen ist, wobei der benachbart der erdfreien Diffusionszone angeordnete gering dotierte Bereich im Abstand von dem Schwellen-Einstellbereich liegt.

**7.** Ausgangsschaltung nach Anspruch 1, dadurch gekennzeichnet, daß der vergrabene Kanal des zweiten MS-Transistors einen im Abstand von der Drain-Elektrode liegenden geringer dotierten Bereich bildet.

**8.** Ausgangsschaltung nach Anspruch 7, dadurch gekennzeichnet, daß der geringer dotierte Bereich zwischen der Drain-Elektrode und dem Kanalbereich des zweiten MOS-Transistors eine Verlängerung des Kanalbereichs bildet.

**9.** Ausgangsschaltung nach Anspruch 3, dadurch gekennzeichnet, daß der Bildsensor aus einem Horizontal-CCD besteht, mit dem die Fotoelemente verbunden sind und das ein Ausgangs-Gate und einen unter dem Ausgangs-Gate angeordneten Kanalbereich aufweist, und daß Mittel vorgesehen sind, die die erdfreie Diffusionszone mit dem Kanalbereich des Horizontal-CCD verbinden.

**10.** Ausgangsschgaltung nach Anspruch 9, dadurch gekennzeichnet, daß die die erdfreie Diffusionszone mit dem Kanalbereich des CCD verbindenden Mittel einen gering dotierten Bereich enthalten, der sich zwischen der erdfreien Diffusionszone und dem Kanalbereich des CCD erstreckt.

**11.** Ausgangsschaltung nach Anspruch 10, dadurch gekennzeichnet, daß der Kanalbereich des CCD ein gering dotierter Bereich ist.

**12.** Bildsensor mit einer Ausgangsschaltung gemäß einem der vorhergehenden Ansprüche.

**Revendications**

**1.** Circuit de sortie pour recevoir séquentiellement des charges et convertir ces charges collectées dans des éléments photo-électriques d'un capteur d'image en un signal de sortie qui contient du bruit, ledit circuit comprenant :
a) un premier transistor MOS à canal enterré (QR) ayant une électrode de grille (20), une région de canal (28) sous l'électrode de grille, et des électrodes de source et de drain, ladite électrode de source ayant une région fortement dopée séparée de la région de canal et une région plus légèrement dopée entre la région fortement dopée (34) et la région de canal pour procurer une diffusion flottante (33) avec une capacité réduite ;
b) un moyen pour appliquer sélectivement des impulsions à l'électrode de grille (20) dudit premier transistor pour remettre à l'état initial le potentiel aux bornes de ladite diffusion flottante (33) et la préparer à recevoir des charges produites dans un élément photo-électrique, et
c) un amplificateur de sortie suiveur de source ayant un second transistor MOS à canal enterré (QD$_1$) comprenant une électrode de grille (40) qui est électriquement connectée à ladite diffusion flottante, une région de canal (28) sous l'électrode de grille, des régions de source et de drain fortement dopées sur les côtés opposés de la région de canal et une région plus légèrement dopée entre la région de drain fortement dopée et la région de canal dudit second transistor, d'où il résulte que ledit amplificateur produit un changement de la tension de sortie en réponse à la charge collectée dans ladite diffusion flottante avec un rapport signal/bruit accru.

**2.** Circuit de sortie selon la revendication 1, dans lequel ledit amplificateur de sortie suiveur de source est d'une configuration à deux étages comportant ledit second transistor dans le premier étage.

**3.** Circuit de sortie selon la revendication 1, dans lequel ledit second transistor comprend un substrat (p-), une région de canal dans le substrat, une couche isolante sur la région de canal, une électrode de grille sur ladite région isolante et sur la région de canal, et des électrodes de source et drain fortement dopées dans le substrat et chacune espacée de la région de canal par une région plus légèrement dopée.

4. Circuit de sortie selon la revendication 3, dans lequel le canal enterré du premier transistor MOS est une région plus légèrement dopée séparée de l'électrode de source.

5. Circuit de sortie selon la revendication 4, dans lequel la région plus légèrement dopée entre la source et la région de canal est une extension de la région de canal.

6. Circuit de sortie selon la revendication 1, comprenant de plus une région d'ajustement de seuil de champ hautement dopée autour du premier transistor MOS avec la région légèrement dopée contiguë à la diffusion flottante étant séparée de la région d'ajustement de seuil.

7. Circuit de sortie selon la revendication 1, dans lequel le canal enterré du second transistor MOS est une région plus légèrement dopée séparée de l'électrode de drain.

8. Circuit de sortie selon la revendication 7, dans lequel la région plus légèrement dopée entre le drain et la région de canal du second transistor MOS est une extension de la région de canal.

9. Circuit de sortie selon la revendication 3, dans lequel le capteur d'image comprend un dispositif à couplage de charge horizontal auquel les éléments photoélectriques sont connectés, le dispositif à couplage de charge comprenant une grille de sortie et une région de canal sous la grille de sortie, et un moyen connectant la diffusion flottante à la région de canal du dispositif à couplage de charge horizontal.

10. Circuit de sortie selon la revendication 9, dans lequel le moyen connectant la diffusion flottante à la région de canal du dispositif à couplage de charge comprend une région légèrement dopée se prolongeant entre la diffusion flottante et la région de canal du dispositif à couplage de charge.

11. Circuit de sortie selon la revendication 10, dans lequel la région de canal du dispositif à couplage de charge est une région légèrement dopée.

12. Capteur d'image comprenant un circuit de sortie comme défini selon l'une quelconque des revendications précédentes.

FIG. 1

FIG. 2

9

FIG. 3

FIG. 4

FIG: 5

FIG. 6